# EUROPÄISCHE PATENTSCHRIFT

(11) **EP 1 880 790 B1**
(45) Veröffentlichungstag und Bekanntmachung des Hinweises auf die Patenterteilung: **07.12.2011**
(21) Anmeldenummer: 07011082.0
(22) Anmeldetag: 06.06.2007
(51) Int. Cl.: B23K 26/08, H01L 31/18, H01L 27/142

(54) **Anlage zur Strukturierung von Solarmodulen**
Facility for structuring solar modules
Installation destinée à la structuration de modules solaires

(30) Priorität: 17.07.2006 DE 102006033296
(43) Veröffentlichungstag der Anmeldung: 23.01.2008
(73) Patentinhaber: Manz Automation AG, 72768 Reutlingen (DE)
(72) Erfinder: Manz, Dieter, 72667 Schlaitdorf (DE)
(74) Vertreter: Kohler Schmid Möbus

(56) Entgegenhaltungen:
- WO-A-2005/074020
- JP-A- 6 071 475
- JP-A- 2001 111 078
- JP-A- 2001 119 048
- US-A- 4 165 132
- US-A- 5 953 591
- US-A- 5 981 864
- US-A1- 2003 029 848
- US-B1- 6 336 775

## Beschreibung

Die Erfindung betrifft eine Anlage zur Strukturierung von Solarmodulen nach dem Oberbegriff des Anspruchs 1.

Zur Herstellung von Dünnschichtsolarmodulen werden Glassubstrate eingesetzt, welche in Beschichtungsanlagen in der Regel mit drei Schichten beschichtet werden. Zur Serienverschaltung der einzelnen Zellen innerhalb eines Solarmoduls werden die Schichten in drei Strukturierungsschritten selektiv aufgetrennt, indem Linien in die Solarmodule eingebracht werden.

Es besteht die Anforderung, diese Strukturierung für Solarmodule mit unterschiedlichem Schichtaufbau auf einer Anlage durchführen zu können.

Aus der JP 06071475 ist eine Laserbearbeitungsanlage bekannt, bei der das Werkstück mittels Vakuum fixiert und auf einem Luftpolster weitertransportiert wird. Diese Anlage erlaubt lediglich eine Bearbeitung von oben im Ausgangsbereich des Werkstücks.

In der WO 2005/074020 A1 ist eine Anlage zur Herstellung von Halbleiterschaltungen bekannt, die mehrere voneinander beabstandete Bearbeitungsstationen aufweist. In jeder Bearbeitungsstation wird das Werkstück durch Vakuumansaugung fixiert. Anschließend wird ein Luftpolster erzeugt, um das Werkstück zur nächsten Bearbeitungsstation transportieren Zu können. Auch hier ist nur eine Bearbeitung im Bereich der Ansaugung des Werkstücks möglich.

Aufgabe der vorliegenden Erfindung ist es deshalb, eine Anlage bereitzustellen, mit der eine größere Flexibilität bei der Strukturierung von Solarzellen erzielt werden kann.

Erfindungsgemäß wird diese Aufgabe gelöst durch eine Anlage mit den Merkmalen des Anspruchs 1.

Mit einer derartigen Anlage ist es möglich, die Werkzeugachse (Querachse) und die Transportachse des Solarmoduls aufzutrennen und zu entkoppeln. Durch die Verwendung, des Luftkissensystems ist ein berührungsloser Transport und eine berührungslose Stützung des Solarmoduls zumindest an einer zu bearbeitenden Stelle möglich. Dadurch wird ein schonender und sicherer Transport der Solarmodulsubstrate gewährleistet.

Das Luftkissensystem ist in einem Bearbeitungsbereich, insbesondere im Bereich der ersten Querachse, durch einen Spalt unterbrochen. Durch diesen Spalt können Laserstrahlen, die zur Strukturierung einer oder mehrerer Schichten verwendet werden können, in das Substrat eingekoppelt werden. Weiterhin kann ein solcher Spalt zur Durchlichteinkopplung für das Einmessen der Substrate sowie zur Durchführung von Qualitätssicherungsschritten mittels Bildverarbeitung verwendet werden.

Besonders bevorzugt ist es, wenn zumindest in einem Bearbeitungsbereich ein Druck-Vakuum-Tisch zur gleichzeitigen Erzeugung eines Vakuums und eines Überdrucks zwischen dem Solarmodul und einer Platte vorgesehen ist. Dadurch wirken gleichzeitig Druck und Vakuum auf das Solarmodul. Dadurch kann der Abstand des Solarmoduls zu der Platte und dadurch auch zu Strukturierungswerkzeugen im Bereich weniger Mikrometer genau gehalten werden.

An der ersten Querachse sind als Strukturierungswerkzeug zumindest Teile eines Lasersystems angeordnet, die quer zur ersten Achsrichtung bewegbar sind. Dadurch ist es möglich, zumindest einen Strukturierungsschritt mit einem Laser durchzuführen, wobei die Einkopplung des Lasers rückseitig durch das Glassubstrat des Solarmoduls hindurch erfolgen kann. Durch die quer zur ersten Achsrichtung (Transportrichtung des Solarmoduls) angeordnete Querachse ist eine Strukturierung parallel zur kurzen als auch zur langen Seite des Solarmoduls möglich.

Bei einer besonders bevorzugten Ausführungsform kann vorgesehen sein, dass Teile mehrerer Lasersysteme an der ersten Querachse angeordnet sind. Dadurch ist es möglich, dass mehrere Laserstrahlen quer zur Bearbeitungsrichtung nebeneinander angebracht sind, sodass mehrere Spuren parallel bearbeitet werden können. Je nach Schichtaufbau des Solarmoduls, insbesondere wenn Zellen aus amorphem Silizium verwendet werden, können alle Schichten des Solarmoduls von der Rückseite des Solarmoduls her mittels eines Lasers strukturiert werden.

Ein Lasersystem im Sinne der Erfindung kann sowohl ein Laser selbst oder ein Laser zusammen mit einer Laseroptik sein. Dabei kann vorgesehen sein, dass an der ersten Querachse ein oder mehrere Laser oder ein oder mehrere Laseroptiken zur Führung von Laserstrahlen vorgesehen sind. Wenn die Laser unmittelbar an der Querachse angeordnet sind, werden diese entlang der Querachse bewegt. Es ist jedoch auch denkbar, einen oder mehrere Laser ortsfest anzuordnen und nur eine Laseroptik oder, wenn mehrere Laserstrahlen gleichzeitig auf das Solarmodul gerichtet werden sollen, mehrere Laseroptiken entlang der Querachse zu bewegen. Alternativ kann an der ersten Querachse ein Strukturierungswerkzeug zur mechanischen Strukturierung vorgesehen sein.

Bei einer besonders bevorzugten Ausführungsform kann eine zweite Querachse vorgesehen sein. Dadurch können mit derselben Anlage weitere Bearbeitungs- oder Analyseschritte durchgeführt werden.

Gemäß einer Weiterbildung können an der zweiten Querachse ein oder mehrere Strukturierungswerkzeuge, insbesondere zur mechanischen Strukturierung und/oder Randentschichtung angeordnet sein. Dadurch wird der Einsatzbereich der Anlage erweitert. Beispielsweise kann eine Schicht mittels Laser und können die weiteren beiden Schichten mittels mechanischer Strukturierungswerkzeuge, beispielsweise Sticheln, bearbeitet werden. Selbstverständlich ist es auch denkbar, an der ersten Querachse mechanische Strukturierungswerkzeuge vorzusehen. An beiden Querachsen können quer zur Achsrichtung der jeweiligen Achse mehrere Strukturierungswerkzeuge vorgesehen sein.

Besondere Vorteile ergeben sich, wenn die zweite Querachse oberhalb der Transportebene angeordnet ist. Somit kann eine Bearbeitung des Solarmoduls von beiden Seiten erfolgen. Je nachdem, in welcher Orientierung das Solarmodul zugeführt werden soll - mit dem Glassubstrat unten oder oben - kann die Bestückung und Anordnung der Querachsen geeignet gewählt werden. Beispielsweise kann die erste Querachse ein Lasersystem aufweisen, das unterhalb der Transportebene angeordnet ist, wobei das Glassubstrat zu dem Lasersystem weist. Zur Strukturierung zumindest einiger nach oben weisender Schichten kann an einer oberhalb der Transportebene angeordneten Querachse ein mechanisches Strukturierungswerkzeug vorgesehen sein. Sollen Solarmodule mit nach oben gerichtetem Glassubstrat zugeführt werden, ist es vorteilhaft, das Lasersystem oberhalb und ein mechanisches Strukturierungswerkzeug unterhalb der Transportebene anzuordnen.

Bei einer Ausführungsform kann vorteilhafterweise an der ersten oder zweiten Querachse ein Einmesssystem zum Einmessen der zu strukturierenden Linien angeordnet sein. Beispielsweise kann als Einmesssystem ein Kamerasystem zum Einmessen der Linien und zur Qualitätsprüfung vorgesehen sein. Dabei kann die Kamera an einer oberhalb der Transportebene angeordneten Querachse zusammen mit einer Beleuchtungseinheit angeordnet sein. Durch die Kamera können der Linienverlauf der zuvor realisierten Strukturierung oder eingebrachte Referenzmarken ermittelt werden. Für das Einmessen der Strukturierungslinie der zweiten Schicht werden beispielsweise alle 10 - 20 cm Messpunkte aufgenommen. Der aufgenommene Linienverlauf ist die Grundlage für die nachfolgende Strukturierung der zweiten Schicht. Hierzu wird eine Kurve über die gemessenen Stützpunkte interpoliert.

Für die Strukturierung der Schichten kann das Einmessen alternativ auch durch das Vermessen von Referenzmarken erfolgen, die z.B. in einem vorhergehenden Schritt eingebracht wurden.

Die Kamera kann außerdem zur Beurteilung der Qualität der erzeugten Linien verwendet werden. Kriterien sind neben der Spurbreite die Lage der Spur und die Qualität (Riefen).

Bei der Strukturierung entstehen Partikel. Deshalb ist es vorteilhaft, wenn die erste oder zweite Querachse eine Absaugeinrichtung aufweist. Insbesondere kann dadurch erreicht werden, dass die entstehenden Partikel vollständig entfernt werden, sodass die spätere Funktionsweise des Solarmoduls nicht beeinträchtigt wird.

Zur genauen Positionierung der Strukturierungswerkzeuge ist es vorteilhaft, wenn an der ersten und/oder zweiten Querachse ein Wegmesssystem vorgesehen ist. Dadurch kann sichergestellt werden, dass die Strukturierung mit einer hohen Genauigkeit erfolgt. Vorzugsweise werden als Wegmesssystem hoch präzise Linearmesssysteme verwendet, wobei eine direkte Wegmessung über Maßstäbe erfolgt.

Weitere Vorteile ergeben sich, wenn an der ersten und/oder zweiten Querachse zum Antrieb der Strukturierungswerkzeuge oder des Einmesssystems Linearmotoren vorgesehen sind. Durch den Einsatz von Linearmotoren wird eine große Dynamik, Präzision und Geschwindigkeit erreicht. Linearantriebe sind wartungsfrei.

Bei einer Ausführungsform können Haltemittel zur Fixierung des Solarmoduls an zumindest einem Randbereich, vorzugsweise wenigstens zwei sich gegenüber liegenden Randbereichen des Solarmoduls, vorgesehen sein. Insbesondere können die Solarmodule an den beiden Längsseiten durch Halteleisten fixiert sein.

Eine genaue Positionierung des Solarmoduls in Transportrichtung kann erreicht werden, wenn die Haltemittel durch Linearmotoren in die erste Achsrichtung antreibbar sind.

Weitere Vorteile ergeben sich, wenn das Transportsystem Ausrichtmittel zum Ausrichten des Solarmoduls aufweist. Dies ist insbesondere dann vorteilhaft, wenn das Solarmodul auf ein Luftkissen aufgesetzt wird. Durch mechanische Zentrierungen kann das Solarmodul in Quer- und Längsrichtung ausgerichtet werden. Sobald das Solarmodul die korrekte Position eingenommen hat, kann es an den beiden Längsseiten durch die Haltemittel fixiert werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert.

Es zeigt:
- Fig. 1: eine perspektivische Ansicht einer erfindungsgemäßen Anlage; und
- Fig. 2: eine Draufsicht auf die erfindungsgemäße Anlage.

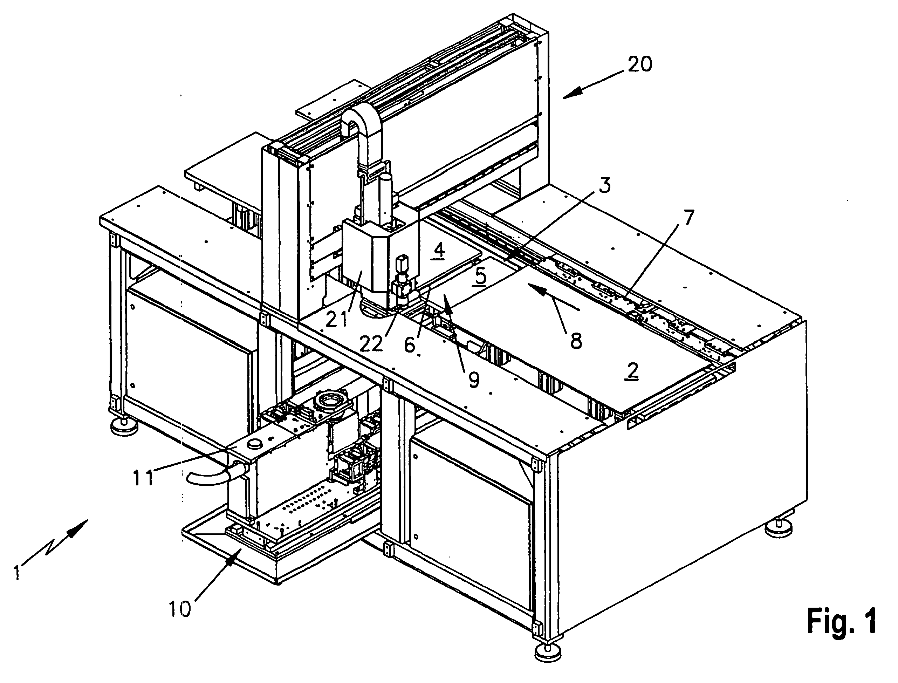

Die Figur 1 zeigt eine Anlage 1 zur Strukturierung von Solarmodulen 2. Über eine nicht dargestellte Schnittstelle zum Be- und Entladen von Solarmodulen 2 wird das Solarmodul 2 auf ein Transportsystem 3 übergeben. Das Transportsystem 3 umfasst ein Luftkissensystem, welches im Ausführungsbeispiel zwei Platten 4, 5 aufweist, die durch einen Spalt 6 getrennt sind. Zumindest im Bereich des Spalts 6 sind Öffnungen in den Platten 4, 5 vorgesehen, durch die die Unterseite des Solarmoduls 2 sowohl mit Überdruck als auch mit einem Vakuum beaufschlagt werden kann. Der Bereich des Spalts 6 kann also als Druck-Vakuum-Tisch ausgebildet sein. Dadurch kann ein Luftkissen erzeugt werden, das das Solarmodul 2 von den Platten 4, 5 konstant beabstandet hält. Das Solarmodul 2 ist zumindest an einer Längsseite über ein als Halteleiste ausgebildetes Haltemittel 7 gehalten. Das Haltemittel 7 ist über nicht dargestellte Linearantriebe in Richtung der ersten Achsrichtung 8 antreibbar. Dadurch kann das Solarmodul 2 in den Bearbeitungsbereich 9 verfahren werden und relativ zu noch näher zu beschreibenden Strukturierungswerkzeugen bewegt werden.

Eine erste Querachse 10 ist im Ausführungsbeispiel unterhalb der Transportebene des Solarmoduls 2 angeordnet. Die Querachse 10 weist als Strukturierungswerkzeug ein Lasersystem 11 auf. Ein Laserstrahl kann durch den Spalt 6 hindurch in das Substrat des Solarmoduls 2 eingekoppelt werden. Dadurch können eine oder mehrere Schichten, die oben auf das Substrat des Solarmoduls 2 aufgebracht wurden, strukturiert werden. Das Lasersystem 11 kann durch einen nicht gezeigten Linearantrieb quer zur Achsrichtung 8 bewegt werden. Durch die Relativbewegung von Lasersystem 11 und Solarmodul 2 kann das Solarmodul 2 sowohl in Achsrichtung 8, also parallel zu seiner Längsseite als auch quer zur Achsrichtung 8, also parallel zu einer kurzen Seite, strukturiert werden.

Die Anlage 1 weist außerdem eine zweite Querachse 20 auf, die in einer Einheit 21 vereint eine Absaugeinrichtung, ein Kamerasystem und ein mechanisches Strukturierungswerkzeug 22 aufweist. Die Absaugeinrichtung, das Kamerasystem und das mechanische Werkzeug 22 müssen nicht notwendigerweise zu einer Einheit zusammengefasst sein, sondern können auch getrennt voneinander an der zweiten Querachse 20 angeordnet sein. Es ist auch nicht notwendig, dass alle drei Einrichtungen ständig vorhanden sind. Es ist beispielsweise denkbar, nur das Kamerasystem vorzusehen.

Die Einheit 21 ist quer zur Achsrichtung 8 über Linearantriebe bewegbar. Beispielsweise kann das mechanische Werkzeug 22 als Stichel ausgebildet sein, sodass Schichten des Solarmoduls 2 mechanisch strukturiert werden können. Durch die Absaugeinrichtung werden während der Strukturierung anfallende Partikel abgesaugt. Es ist vorstellbar, dass an der Einheit 21 mehrere mechanische Werkzeuge 22 in Achsrichtung 8 nebeneinander angeordnet sind. Das Kamerasystem kann zum Einmessen von Linien verwendet werden.

Nicht dargestellt sind Schutzeinrichtungen zum Schutz von Benutzern vor Laserstrahlung. Das Lasersystem 11 sowie die Einheit 21 können an die Querachsen 10, 20 ankoppelbar und damit auch austauschbar sein. Weiterhin ist es denkbar, dass die mechanischen Strukturierungswerkzeuge 22 an der Einheit 21 angekoppelt und somit austauschbar angeordnet sind.

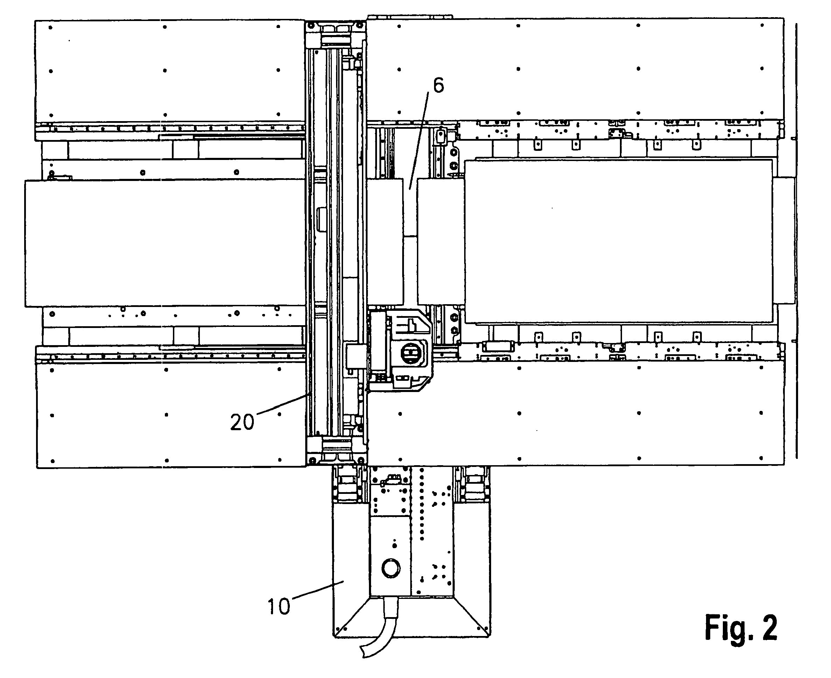

In der Draufsicht der Figur 2 ist zu erkennen, dass der Spalt 6 über der ersten Querachse 10, jedoch versetzt zur zweiten Querachse 20 angeordnet ist.

## Patentansprüche

1. Anlage (1) zur Strukturierung von Solarmodulen (2), umfassend ein Transportsystem (3) zum Transport eines Solarmoduls (2) in einer Transportebene in eine erste Achsrichtung (8) und einer ersten Querachse (10) mit einem Strukturierungswerkzeug (11), wobei das Transportsystem (3) ein Luftkissensystem aufweist, **dadurch gekennzeichnet, dass** die ersten Querachse (10) unterhalb der Transportebene angeordnet ist und an der ersten Querachse (10) als Strukturierungswerkzeug zumindest Teile eines Lasersystems (11) angeordnet sind, die quer zur ersten Achsrichtung (8) bewegbar sind, und dass das Luftkissensystem in einem Bearbeitungsbereich (9), insbesondere im Bereich der ersten Querachse (10), durch einen Spalt (6) unterbrochen ist.

2. Anlage nach Anspruch 1, **dadurch gekennzeichnet, dass** zumindest in einem Bearbeitungsbereich (9) ein Druck-Vakuum-Tisch zur gkeichzeitigen Erzeugung eines Vakuums und eines Überdrucks zwischen dem Solarmodul (2) und einer Platte (4, 5) vorgesehen ist.

3. Anlage nach Anspruch 1 oder 2, **dadurch gekennzeichnet, dass** Teile mehrerer Lasersysteme (11) an der ersten Querachse (10) angeordnet sind.

4. Anlage nach einem der vorhergehenden Ansprüche, **dadurch gekennzeichnet, dass** an der ersten Querachse (10) ein oder mehrere Laser oder ein oder mehrere Laseroptiken zur Führung von Laserstrahlen vorgesehen sind.

5. Anlage nach einem der vorhergehenden Ansprüche, **dadurch gekennzeichnet, dass** eine zweite Querachse (20) vorgesehen ist.

6. Anlage nach Anspruch 5, **dadurch gekennzeichnet, dass** an der zweiten Querachse (20) ein oder mehrere Strukturierungswerkzeuge (22), insbesondere zur mechanischen Strukturierung und/oder Randentschichtung angeordnet sind.

7. Anlage nach Anspruch 5 oder 6, **dadurch gekennzeichnet, dass** die zweite Querachse (20) oberhalb der Transportebene angeordnet Ist.

8. Anlage nach einem der vorhergehenden Ansprüche, **dadurch gekennzeichnet, dass** an der ersten oder zweiten Querachse (10, 20) ein Einmesssystem zum Einmessen der zu strukturierenden Linien angeordnet ist.

9. Anlage nach einem der vorhergehenden Ansprüche, **dadurch gekennzeichnet, dass** die erste oder zweite Querachse (10, 20) eine Absaugeinrichtung aufweist.

10. Anlage nach einem der vorhergehenden Ansprüche, **dadurch gekennzeichnet, dass** an der ersten und/oder zweiten Querachse (10, 20) ein Wegmesssystem vorgesehen ist.

11. Anlage nach einem der vorhergehenden Ansprüche, **dadurch gekennzeichnet, dass** an der ersten und/oder zweiten Querachse (10, 20) zum Antrieb der Strukturierungswerkzeuge (11, 22) oder des Einmesssystems Linearmotoren vorgesehen sind.

12. Anlage nach einem der vorhergehenden Ansprüche, **dadurch gekennzeichnet, dass** Haltemittel (7) zur Fixierung des Solarmoduls (2) an zumindest einem Randbereich des Solarmoduls (2) vorgesehen sind.

13. Anlage nach Anspruch 12, **dadurch gekennzeichnet, dass** die Haltemittel (7) durch Linearmotoren in die erste Achsrichtung (8) antreibbar sind.

14. Anlage nach einem der vorhergehenden Ansprüche, **dadurch gekennzeichnet, dass** das Transportsystem (3) Ausrichtmittel zum Ausrichten des Solarmoduls (2) aufweist.

## Claims

1. Machine (1) for scribing solar modules (2), comprising a transport system (3) for transporting a solar module (2) in a first axial direction (8) in a transport plane and a first transverse axis (10) with a scribing tool (11), the transport system (3) comprising an air-cushion system, **characterized in that** the first transverse axis (10) is arranged below the transport plane and at least parts of a laser system (11) which can be moved transversely with respect to the first axial direction (8) are arranged on the first transverse axis (10) as the scribing tool, and **in that** the air-cushion system is interrupted by a gap (6) in a processing zone (9), in particular in the region of the first transverse axis (10).

2. Machine according to Claim 1, **characterized in that** a pressure/vacuum table for simultaneously generating a vacuum and positive pressure between the solar module (2) and a platen (4, 5) is provided at least within a processing zone (9).

3. Machine according to Claim 1 or Claim 2, **characterized in that** parts of a plurality of laser systems (11) are arranged on the first transverse axis (10).

4. Machine according to any one of the preceding claims, **characterized in that** one or more lasers or one or more laser optics for guiding laser beams are provided on the first transverse axis (10).

5. Machine according to any one of the preceding claims, **characterized in that** a second transverse axis (20) is provided.

6. Machine according to Claim 5, **characterized in that** one or more scribing tools (22), in particular for mechanical scribing and/or edge ablation, are arranged on the second transverse axis (20).

7. Machine according to Claim 5 or Claim 6, **characterized in that** the second transverse axis (20) is arranged above the transport plane.

8. Machine according to any one of the preceding claims, **characterized in that** a calibration system for calibrating the lines to be scribed is arranged on the first or second transverse axis (10, 20).

9. Machine according to any one of the preceding claims, **characterized in that** the first or second transverse axis (10, 20) carries an extraction system.

10. Machine according to any one of the preceding claims, **characterized in that** a position sensing system is provided on the first and/or second transverse axis (10, 20).

11. Machine according to any one of the preceding claims, **characterized in that** linear motors for driving the scribing tools (11, 22) or the position sensing system are provided on the first and/or second transverse axis (10, 20).

12. Machine according to any one of the preceding claims, **characterized in that** holding means (7) are provided for fixing the solar module (2) in at least an edge region of the solar module (2).

13. Machine according to Claim 12, **characterized in that** the holding means (7) are drivable in the first axial direction (8) by linear motors.

14. Machine according to any one of the preceding claims, **characterized in that** the transport system (3) has aligning means for aligning the solar module (2).

## Revendications

1. Installation (1) pour la structuration de modules solaires (2), comprenant un système de transport (3) pour transporter un module solaire (2) dans un plan de transport dans une première direction axiale (8) et un premier axe transversal (10) avec un outil de structuration (11), dans laquelle le système de transport (3) présente un système à coussin d'air, **caractérisée en ce que** le premier axe transversal (10) est agencé en dessous du plan de transport et, comme outil de structuration, au moins des parties d'un système à laser (11) sont agencées sur le premier axe transversal (10), lesquelles parties peuvent être déplacées transversalement à la première direction axiale (8), et **en ce que** le système à coussin d'air est interrompu dans une zone de traitement (9), en particulier dans la zone du premier axe transversal (10), par une fente (6).

2. Installation selon la revendication 1, **caractérisée en ce qu'**au moins dans une zone de traitement (9), on prévoit une table de pression et de vide pour générer simultanément un vide et une surpression entre le module solaire (2) et une plaque (4, 5).

3. Installation selon la revendication 1 ou 2, **caractérisée en ce que** des parties de plusieurs systèmes à laser (11) sont agencées sur le premier axe transversal (10).

4. Installation selon l'une quelconque des revendications précédentes, **caractérisée en ce que**, sur le premier axe transversal (10), on agence un ou plusieurs lasers ou une ou plusieurs optiques laser pour guider des rayons laser.

5. Installation selon l'une quelconque des revendications précédentes, **caractérisée en ce que** l'on prévoit un second axe transversal (20).

6. Installation selon la revendication 5, **caractérisée en ce qu'**on agence un ou plusieurs outils de structuration (22) sur le second axe transversal (20), en particulier pour la structuration mécanique et/ou l'enlèvement de la couche périphérique.

7. Installation selon la revendication 5 ou 6, **caractérisée en ce que** le second axe transversal (20) est agencé au-dessus du plan de transport.

8. Installation selon l'une quelconque des revendications précédentes, **caractérisée en ce qu'**un système de mesure pour mesurer les lignes à structurer est agencé sur le premier ou le second axe transversal (10, 20).

9. Installation selon l'une quelconque des revendications précédentes, **caractérisée en ce que** le premier ou le second axe transversal (10, 20) présente un dispositif d'aspiration.

10. Installation selon l'une quelconque des revendications précédentes, **caractérisée en ce qu'**un système de mesure de trajet est prévu sur le premier axe transversal et/ou le second axe transversal (10, 20).

11. Installation selon l'une quelconque des revendications précédentes, **caractérisée en ce que** l'on prévoit des moteurs linéaires sur le premier axe transversal et/ou le second axe transversal (10, 20) pour entraîner les outils de structuration (11, 22) ou le système de mesure.

12. Installation selon l'une quelconque des revendications précédentes, **caractérisée en ce que** l'on prévoit des moyens de retenue (7) pour fixer le module solaire (2) sur au moins une zone périphérique du module solaire (2).

13. Installation selon la revendication 12, **caractérisée en ce que** les moyens de retenue (7) peuvent être entraînés par des moteurs linéaires dans la première direction axiale (8).

14. Installation selon l'une quelconque des revendications précédentes, **caractérisée en ce que** le système de transport (3) présente des moyens d'orientation pour orienter le module solaire (2).
